Europäisches Patentamt

European Patent Office

Office européen des brevets

(11) Publication number: **0 030 824**
**B1**

# EUROPEAN PATENT SPECIFICATION

(45) Date of publication of patent specification: **24.06.87**

(51) Int. Cl.⁴: **G 06 G 7/186,** H 03 H 19/00

(21) Application number: **80304374.4**

(22) Date of filing: **04.12.80**

(54) An integrator with a switched capacitor and its use in a filter.

(30) Priority: **05.12.79 JP 168361/79**

(43) Date of publication of application:
**24.06.81 Bulletin 81/25**

(45) Publication of the grant of the patent:
**24.06.87 Bulletin 87/26**

(84) Designated Contracting States:
**DE FR GB**

(56) References cited:
**US-A-3 836 893**

**ELECTRONICS, April 1948, New York, US, G.A. KORN: "Elements of D-C. Analog computers", pages 122-127**

**IBM TECHNICAL DISCLOSURE BULLETIN, vol. 9, no. 4, September 1966, New York, US, A.W. BIDWELL et al.: "Peak detector and average detector", pages 426-428**

**ELECTRONIC ENGINEERING, vol. 36, no. 441, November 1964, London, GB, J.K. MOSS: "A transistor linear sawtooth generator with negligible step", pages 772-775**

(73) Proprietor: **FUJITSU LIMITED**
**1015, Kamikodanaka Nakahara-ku**
**Kawasaki-shi Kanagawa 211 (JP)**

(72) Inventor: **Akihiko, Ito**
**No. 3780, Suge, Tama-ku**
**Kawasaki-shi Kanagawa, 214 (JP)**
Inventor: **Kazuhiro, Kobayashi**
**No. 7-5, Kitasuna 7-chome**
**Koto-ku Toyko, 136 (JP)**
Inventor: **Hisami, Tanaka**
**No. 1-17-3-301, Utsukushigaoka Midori-ku**
**Yokohama-shi Kanagawa, 227 (JP)**
Inventor: **Norio, Ueno**
**No. 540, Kosugi-cho 1-chome Nakahara-ku**
**Kawasaki-shi, Kanagawa, 211 (JP)**

(74) Representative: **Bedggood, Guy Stuart et al**
**Haseltine Lake & Co. Hazlitt House 28**
**Southampton Buildings Chancery Lane**
**London WC2A 1AT (GB)**

**0 030 824**

(56) References cited:

ELECTRONIQUE ET MICROELECTRONIQUE
INDUSTRIELLES, no. 158, 1st June 1972, Paris,
FR, R. FONTENAY: "Un amplificateur
operationnel de 0,1 pA d'offset et ses
applications", pages 49-52

JOURNAL OF THE INSTITUTION OF
ELECTRONICS AND TELECOMMUNICATIONS
ENGINEERS, vol. 20, no. 7, July 1974, New
Delhi, IN, H.S. RAINA: "A new type of sample
and hold circuit", page 374

ELECTRONICS LETTERS, vol. 15, no. 20, 27th
September 1979, Hitchin, Herts, GB, T.R.
VISWANATHAN et al.: "MOS switched-
capacitor amplifiers", pages 634-635

IEEE JOURNAL OF SOLID-STATE CIRCUITS,
vol. SC-13, no. 3, June 1978, New York, US,
D.A. HODGES et al.: "Potential of MOS
technologies for analog integrated circuits",
pages 285-293

### Description

The present invention relates to an integrator with a switch capacitor.

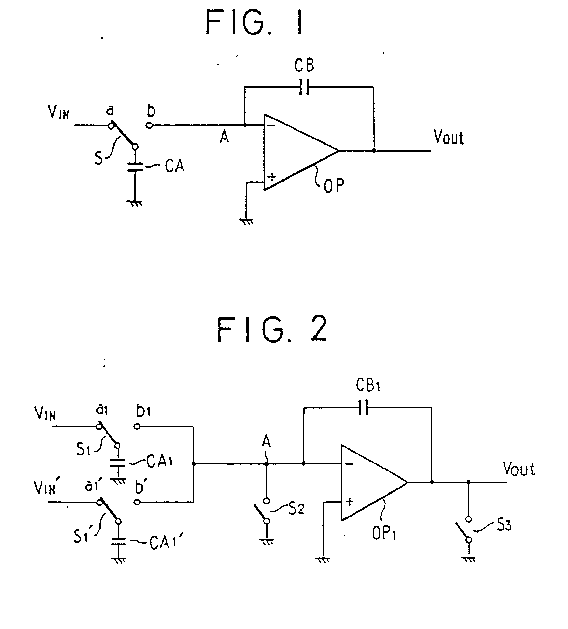

It is well-known in the art that in a switched capacitor-filter, an integrator such as is shown in the schematic circuit diagram of Figure 1 of the accompanying drawings is used as a fundamental unit of the filter (see, for example, IEEE Journal of Solid-State Circuits, Vol. SC.12, No. 6. December 1977, pp. 600—608). In Figure 1, the integrator includes a switched capacitor, which comprises a capacitor CA and a switching element S for periodically switching the capacitor CA to input and output sides $a$ and $b$ of the switching element S, an operational amplifier OP having one input end connected to the output side $b$ of the switching element S and having another input end connected to a reference potential source, in the illustrated example ground, and an integrating capacitor CB connected between the said one input end of the operational amplifier OP and an output end of the operational amplifier OP. The operation of the integrator is as follows. Ideally the DC gain and input impedance of the operational amplifier OP are infinite and its output impedance is zero. If the operational amplifier OP is assumed to be ideal, then the potential at a point A in Figure 1 is zero. In a case in which the switching element S is connected to the input side $a$ when t=0, and letting an input voltage $V_{IN}$ at that time be represented by $V_{IN0}$, charges $Q_A = V_{IN0} \cdot CA$ are stored into capacitor CA. Next, upon changing over of the switching element S to its output side $b$ from its input side $a$ when $t=t_1$, the charges $Q_A = V_{IN0} \cdot CA$ are injected to the point A and thence applied to the capacitor CB. Accordingly, the output voltage Vout from the operational amplifier OP long after the moment $t=t_1$ becomes as follows:—

$$Vout = Vout_0 - \frac{CA}{CB} V_{IN0} \qquad (1)$$

where $Vout_0$ is the output voltage of the operational amplifier OP at the moment at which the switching element S is changed over to the output side $b$. The reason for this is that since the output of the operational amplifier OP is fed back to its input side, and if the potential at the point A is zero as described above, charges from the capacitor CA are all transferred to the integrating capacitor CB to make its potential equal to the output voltage Vout. Repeating the above operation of first connecting the switching element S to its input side $a$, and then to its output side $b$, the output voltage Vout becomes as follows:

$$Vout = Vout_0 - n \frac{CA}{CB} V_{IN0} \qquad (2)$$

where $n$ is the number of periodical changes of the switching element S from its input side to its output side. In the above expressions, $V_{IN0}$ has been assumed to be constant; if it is a function of time, then the second term in each of the expressions (1) and (2) becomes an integral term.

While the integrator of Figure 1 continuously operates with repeated change over of the switching element S between the input and output sides $a$ and $b$, there is no problem, but when the integrator is out of operation, there arises the following problem. That is, while the integrator is out of operation, what is called a power-down procedure is effected with a view to avoiding unnecessary power consumption, and this is carried out by turning OFF entirely or partly the power source of the operational amplifier OP to stop it functioning. As a consequence, the function of holding the point A (i.e. the said one input end of the operational amplifier) at the potential of the other input end of the operational amplifier (in this example at zero level) is lost and the point A assumes an unfixed potential which depends on leakage current, induction or the like. When the potential at the point A becomes unfixed, and for example becomes a positive or negative high potential in a case in which the integrator is held out of operation for a long time, it is necessary that the commencement of a subsequent integral operation, the abovesaid high potential be reduced to zero via the negative feedback circuit including the integrating capacitor; accordingly, much time is required until the potential at the point A becomes stable.

Electronics, April 1948, page 122 et seq., in an article by Korn on Elements of D-C Analog Computers discusses, inter alia, the setting up of a D-C analog computer, and discloses that whilst initial conditions are being set up the computer is made inoperative by grounding the grids or input terminals of all integrators. Figure 2(B) of the article shows the use of a system of relays for this purpose in an arrangement having a resistor, a capacitor, an amplifier and a variable voltage source.

IBM Technical Disclosure Bulletin, Vol. 9, No. 4, September 1966, pages 426 to 428, in an article by Bidwell et al, discloses an average detector having a differential amplifier one input terminal of which receives a signal to be detected via a resistor and another input terminal of which receives a waveform for control. A capacitor is connected between the said one input terminal of the amplifier and its output terminal. Transistors are connected between the ends of the capacitor and ground. In an operational cycle of the detector the transistors are both off, one on, and both on (to discharge the capacitor) in turn.

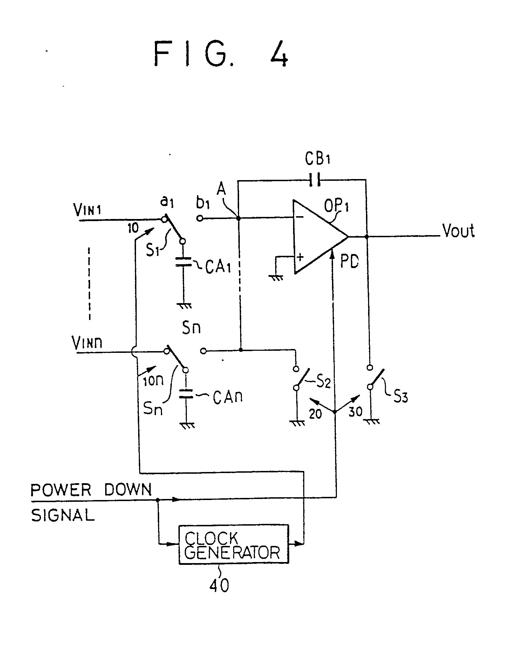

US—A—3 836 893 discloses in Fig. 4 a capacitive storage circuit in which compensation for stray capacitance is provided. A voltage sensing amplifier, subject to stray capacitance across its non-inverting and negative inputs, and having a feedback capacitor between its output and its negative input, has switches for shorting its inputs and the feedback capacitor to prevent accumulation of leakages charges in the stray capacitance and the feedback capacitor.

The Journal of the Institution of Electronics and Telecommunication Engineers (India), Vol. 20, No. 7, July 1974, page 374, in an article by Raina, discloses a sample and hold circuit in which an operational amplifier has a capacitor connected between its output and an input, for integration. A transistor is employed to clear any initial charge existing across the capacitor.

The "Semiconductor Memory Book" (Intel Marketing Communications), John Wiley and Sons, New York, 1978, page 9, discloses the use of a power down mode for a semiconductor memory.

The above-mentioned IEEE Journal of Solid-state Circuits, Vol. SC.12, No. 6, December 1977, pp. 600—608, discloses an integrator having the features stated in the precharacterising part of claim 1.

According to the present invention there is provided an integrator, fabricated as an integrated circuit, with a switched capacitor comprising a capacitor and a field effect transistor switching element, which switching element can be periodically changed over for charging the capacitor with an input voltage through the switching element and for discharging the capacitor through the switching element, an operational amplifier, connected at one input end thereof with the switched capacitor to receive charges from the capacitor when discharged, and supplied at another input end thereof with a reference potential, and an integrating capacitor connected between an output end of the operational amplifier and the said one input end of the operational amplifier, characterised in that the operational amplifier has a terminal for receiving a power-down signal in response to which supply of power to a part or the whole of the circuitry of the amplifier is terminated to put the amplifier out of operation, that the switching of the capacitor is suspended during the time of application of the power-down signal to the operational amplifier, and that a further field effect transistor switching element is connected to the said one input end of the operational amplifier and is arranged so that it is switched to keep the potential of the said one input end equal to the reference potential during that same time.

An embodiment of the present invention can provide an integrator which is free from the above described defect of the prior art, and in which a field effect transistor switching element is connected to the input end, or to either of the input and output ends of, an operational amplifier of the integrator, to connect the input and/or output ends to a reference potential source, for instance ground, and, during suspension of integral operation of the operational amplifier, input and output ends of the operational amplifier are clamped at the reference potential, thereby to prevent an end potential of the operational amplifier from becoming unfixed and hence to avoid prolongation of a time necessary for stabilizing of end potential at the start of an integral operation.

An integrator embodying the present invention can be used in a switched capacitor-filter or the like.

Reference is made, by way of example, to the accompanying drawings, in which:—

Figure 1 is a schematic circuit diagram of a conventional integrator;

Figure 2 is a schematic circuit diagram for assistance in explanation of a first embodiment of the present invention;

Figure 3 is a schematic circuit diagram for assistance in explanation of a second embodiment of the present invention;

Figure 4 is a schematic circuit diagram for assistance in explanation of an operation for applying a power-down control signal in the embodiment of Figure 3;

Figure 5 is a timing chart for assistance in · explanation of operations involved in application of a power-down control signal in the embodiment of Figure 3; and

Figure 6 is a schematic circuit diagram for assistance in explanation of a third embodiment of the present invention.

Figure 2 illustrates a first integrator embodying the present invention. In Figure 2, a capacitor $CA_1$ and a switching element $S_1$ constitute a resistance-capacitance element which forms a switched capacitor as aforementioned, and a capacitor $CA_1'$ and a switching element $S_1'$ similarly constitute a resistance-capacitance element which forms a second switched capacitor. The first and second switched capacitors receive input voltages $V_{IN}$ and $V_{IN}'$ respectively, and both apply their outputs to one input end of an operational amplifier $OP_1$. Another input end of the operational amplifier $OP_1$ is connected to ground. Reference character $CB_1$ indicates an integrating capacitor connected between input and output ends of the operational amplifier $OP_1$, $S_2$ designates a switching element connected between the one input end of the operational amplifier $OP_1$ and ground, and $S_3$ identifies a switching element connected between the output end of the operational amplifier $OP_1$ and ground. In this embodiment the one input end of the operational amplifier is a negative input end and the other (grounded) input end is a positive input end but the polarities of the input ends may be reversed, in which case it is a matter of course that the negative signs in the second terms of the expressions (1) and (2) change to positive signs.

When the operational amplifier $OP_1$ is in operation, the switching elements $S_2$ and $S_3$ are both held in OFF (open circuit) states and when the operational amplifier $OP_1$ is out of operation, they are held in ON (closed) states to maintain the said one input end of the operational amplifier $OP_1$ at zero level. The switching elements $S_2$ and $S_3$ may be formed of field effect transistors, which may be formed as one integrated circuit on a common semiconductor substrate together with semiconductor elements constituting the integrator. The assembly is used, for instance, as a general-purpose basic filter block.

Next, a description will be given of the operation of the abovesaid first embodiment of the present invention. In a case in which one of the switching elements $S_1$ and $S_1'$ of the switched capacitors performs a switching operation, the result is the same as described previously and the integrated output Vout becomes such as is indicated by expression (2) above. When the switching elements $S_1$ and $S_1'$ both perform switching operations at the same time, the output voltage Vout becomes as follows:

$$Vout=Vout_0-n \frac{CA_1}{CB_1} V_{IN0}-m \frac{CA_1'}{CB_1} V_{IN0} \quad (3)$$

where $m$ is the number of switching operations (from input side to output side) of the switching element $S_1'$ and $n$ is the number of switching operations of the switching element $S_1$. When integral operation is suspended, the switching elements $S_1$ and $S_1'$ of the switched capacitor are prevented from carrying out switching and the switching elements $S_2$ and $S_3$ are turned ON. As a result, the reference point A is clamped to ground potential and even if external charges flow into reference point A, its potential is not varied and is retained at zero level. In order to reactivate the integrator from such a state, the switching elements $S_2$ and $S_3$ which have been closed until then are opened and the switching elements $S_1$ and $S_1'$ of the switched capacitors are started again, whereby charging and discharging of the integrating capacitors $CA_1$ and $CA_1'$ is resumed to start integral operation of the integrator. In addition, at the start of the integral operation, the potential at the point A lies at zero volts which is the desired potential during integral operation, and the output voltage also has a value close to the voltage desired during the integral operation (usually about 3 V at highest), so that the integral operation immediately becomes stable; namely, no long transient time is required until the operation becomes stable.

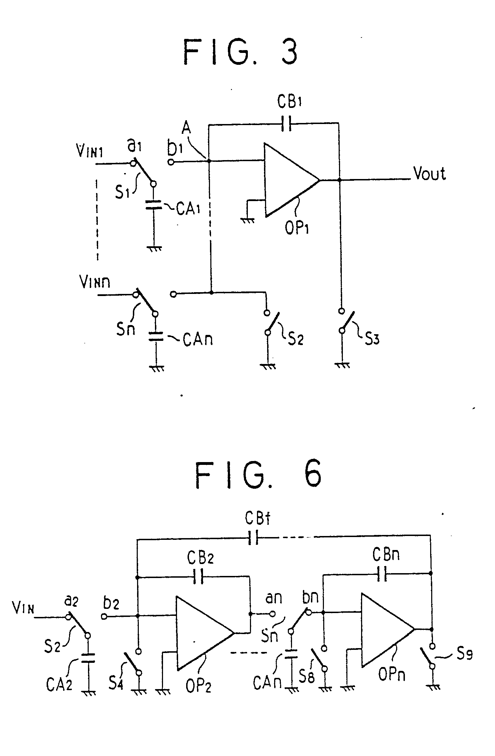

Figure 3 illustrates a second embodiment of the present invention. In Figure 3, parts corresponding to those in the foregoing embodiment are identified by the same reference characters. Reference characters $CA_1$, ... $CA_n$ and $S_1$ ... $S_n$ indicate $n$ capacitors and $n$ switching elements which constitute $n$ switched capacitors; $OP_1$ designates an operational amplifier; $CB_1$ is an integrating capacitor; $S_2$ denotes a switching element connected between one input end of the operational amplifier $OP_1$ and ground; and $S_3$ represents a switching element connected between the output end of the operational amplifier $OP_1$ and ground. The integrator of this embodiment is substantially the same as the integrator of the foregoing embodiment except that $n$ switched capacitors are employed, so that when the $n$ switched capacitors are operated at the same time, the output voltage Vout of the integrator is given by the following expression (4), in which the aforesaid expression (3) is extended:

$$Vout=Vout_0- \sum_{i=1}^{n} m_i \frac{CA_i}{CB_1} V_{INI} \quad (4)$$

where $m_i$ is a positive integer.

Embodiments of the present invention are of particular utility when employed for returning a circuit to its normal mode of operation from a power-down mode in which the circuit has been held for the purpose of cutting power consumption and when no circuit operation is required; namely, embodiments of the present invention are effective in speeding up restoration of the circuit operation.

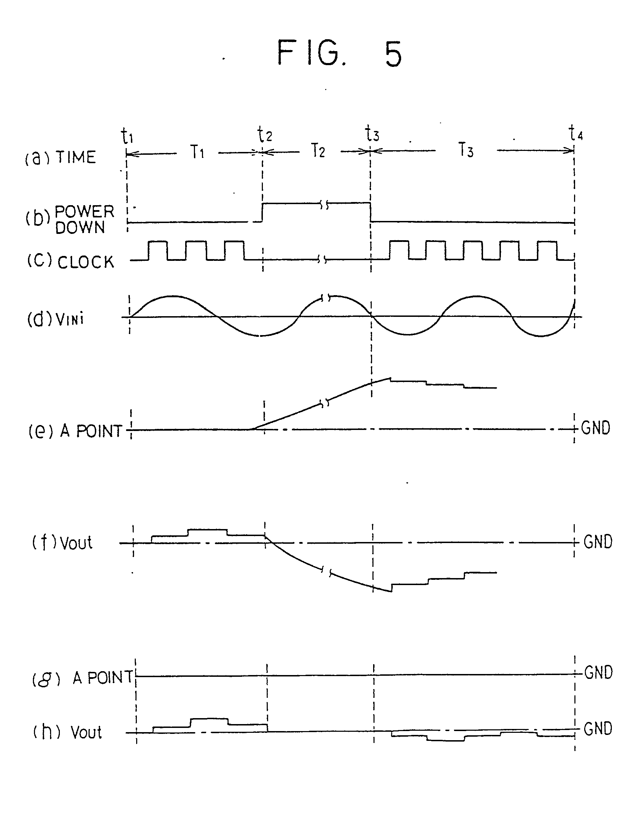

Figure 4 is explanatory of the application of a power-down control signal in the embodiment of the present invention shown in Figure 3, and Figure 5 is a timing chart explanatory of the operations involved.

In Figure 4 parts corresponding to those in Figure 3 are identified by the same reference characters. Reference numeral 40 indicates a clock generator; arrows 10 and 10n designate clock signals which are applied to the switching elements $S_1$ and $S_n$, respectively; arrows 20 and 30 identify power-down control signals which are provided to the switching elements $S_2$ and $S_3$, respectively; and PD denotes a terminal for applying a power-down signal to the operational amplifier.

In Figure 5, (a) shows timing; (b) illustrates a mode in which the power-down signal is applied to the operational amplifier $OP_1$ at a moment $t_2$ which is then reactivated at a moment $t_3$; (c) shows switching timing of one of the switching elements ($S_1$ to $S_n$), (d) shows an input waveform $V_{INI}$, (e) and (f) respectively show the voltage at the point A and the output voltage Vout as they would be were the present invention not embodied in the circuit of Figure 3, that is, as they would be were the switching elements $S_2$ and $S_3$ not used; and (g) and (h) respectively show the voltage at the point A and the output voltage Vout in the embodiment of Figure 3.

In Figure 5 reference character GND indicates ground potential and $T_1$, $T_2$ and $T_3$ respectively indicate operation periods.

A description will be given, with reference to Figure 5, of the embodiment of the Figure 3 as illustrated in Figure 4.

In the period $T_1$ between moments $t_1$ and $t_2$ the integrator performs its normal operations and clock pulses are generated for carrying out integral operations. At the moment $t_2$ power-down signal is applied to the terminal PD of the operational amplifier $OP_1$. When the power-down signal assumes a "H" (high) level, the output end of the operational amplifier becomes of high-impedance, the switching elements $S_2$ and $S_3$ are turned ON and the operation of the clock generator 40 is stopped to discontinue the application of the clock pulses to the switching elements $S_1$ to $S_n$ to stop the integral operation, thus reducing the overall power consumption.

In this case, were the switching elements $S_2$ and $S_3$ not used, it could happen that the voltage at the point A would become as shown in (e) due to backward saturated currents flowing between the sources and drains of transistors (usually field effect transistors) forming the switching elements $S_1$ to $S_n$ and that the output voltage Vout would become such as is shown in (f). In such a case, even if switching from the power-down mode to the normal mode of operation takes place at the moment $t_3$, no normal integral operation can be achieved until the potential at the point A reaches ground level; namely, time is wasted before restarting normal integral operation.

In contrast thereto, in the case in which the switching elements $S_2$ and $S_3$ are employed, the potentials at the point A and the output terminal Vout are fixed to ground level as shown in (g) and (h) at the moment when the power-down signal is applied, and when switching back from the power-down mode to the normal mode of operation takes place at the moment $t_3$, the integral operation can be rapidly resumed without undue delay.

Figure 6 illustrates a third embodiment of the present invention in which a switched capacitor-filter is constituted by a series connection of a plurality of integrators each of which is a fundamental unit of the filter.

In Figure 6, reference characters $CA_2$ and $S_2$, $CA_n$ and $S_n$ indicate capacitors and switching elements forming switched capacitors; $OP_2$ to $OP_n$ designate operational amplifiers; $CB_2$ to $CB_n$ and $CB_f$ identify integrating capacitors; and $S_4$ and $S_8$ and $S_9$ denote switching elements. The number of unit integrators to be cascade-connected and the integrating time constant of each integrator depend on the transfer function of the filter which it is desired to obtain. Also in such a filter, during suspension of its operations, the switching elements $S_4$ to $S_9$ at the input and output ends of the operational amplifiers $OP_2$ to $OP_n$ are closed (in ON state) as in the foregoing embodiments, thereby clamping the potentials at the input and output ends to ground potential. This prevents potential straying, to ensure that at the start of operations the operational amplifiers $OP_2$ and $OP_n$ quickly enter into their stable states. In Figure 6 a switching element for grounding the output end of the operational amplifier $OP_2$ is not shown but it is desirable to ground this output end with a power-down signal.

In this embodiment terminals of the capacitors $CA_1$, $CA_n$ of the switched capacitors on the opposite side from the terminals of the capacitors connected to the switching elements $S_2$, $S_n$ and the plus input sides of the operational amplifiers are shown to be grounded but they may alternatively be held at any other desired potential or at different potentials for different operational amplifiers. In such a case, it is a matter of course that the switching elements $S_2$, $S_3$, are each connected between a source of the potential appropriate to the operational amplifiers or to each different operational amplifier and one input end of the corresponding operational amplifier. The switching elements $S_2$, $S_3$ ... may be PMOS, NMOS, CMOS, switches or the like.

As has been described above, an integrator embodying the present invention employs switching elements for clamping an input side, or input and output sides of the or each operational amplifier of the integrator to a reference level while the operational amplifier is out of operation, so that upon restarting of integral operation after suspension thereof, the integral operation can rapidly be made stable. Further, since the switching elements so employed can be manufactured simultaneously with the formation of a switch of the switched capacitor of the integrator and can be miniaturised, an integrator embodying the present invention has the advantage that it can be produced without any particular modifications of conventional manufacturing steps and IC design.

Thus, an embodiment of the present invention provides an integrator for use, for example, in a switched capacitor-filter, in which switching elements are provided at input and output ends of an operational amplifier of the integrator for clamping those ends to the ground potential during suspension of integral operation, whereby to prevent potentials at the input and output ends of the operational amplifier from becoming unfixed and hence to ensure rapid stabilization of the integral operation of the integrator.

## Claims

1. An integrator, fabricated as an integrated circuit, with a switched capacitor comprising a capacitor and a field effect transistor switching element, which switching element can be periodically changed over for charging the capacitor with an input voltage through the switching element and for discharging the capacitor through the switching element, an operational amplifier, connected at one input end thereof with the switched capacitor to receive charges from the capacitor when discharged, and supplied at another input end thereof with a reference potential, and an integrating capacitor connected between an output end of the operational amplifier and the said one input end of the operational amplifier, characterised in that the operational amplifier has a terminal for receiving a power-down signal in response to which supply of power to a part or the whole of the circuitry of the amplifier is terminated to put the amplifier out of operation, that the switching of the capacitor is suspended during the time of application of the power-down signal to the operational amplifier, and that a further field effect transistor switching element is connected to the said one input end of the operational amplifier and is arranged so that it is switched to keep the potential of the said one input end equal to the reference potential during that same time.

2. An integrator as claimed in claim 1, characterised in that a second further field effect transistor switching element is connected to the said output end of the operational amplifier and is arranged so that it is switched to keep the potential of the said output end equal to the reference potential during the application of a power-down signal to the operational amplifier.

3. A switched capacitor-filter, comprising a plurality of integrators as claimed in any preceding claim connected in series.

## Patentansprüche

1. Integrator, hergestellt als eine integrierte Schaltung, mit einem geschalteten Kondensator, der einen Kondensator und ein Feldeffekt - Transistorschaltelement umfaßt, welches Schaltelement periodisch umgeändert werden kann, um den Kondensator durch das Schaltelement mit einer Eingangsspannung aufzuladen und um den Kondensator durch das Schaltelement zu entladen, einem Operationsverstärker, der an seinem einen Eingangsende mit dem geschalteten Kondensator verbunden ist, um Ladungen von den Kondensator zu empfangen, wenn dieser entladen wird, und dessen anderem Eingangsende ein Referenzpotential zugeführt wird, und einem integrierten Kondensator, der zwischen einem Ausgangsende des Operationsverstärkers und dem genannten einen Eingangsende des Operationsverstärkers verbunden ist, dadurch gekennzeichnet, daß der Operationsverstärker einen Anschluß zum Empfang eines Stromabschaltsignals hat, in Abhängigkeit von welchem die Zufuhr von Energie zu einem Teil oder zu der gesamten Schaltung des Verstärkers beendet wird, um den Verstärker außer Betrieb zu setzen, daß die Schaltung des Kondensators während der Zeit der Zuführung des Stromabschaltsignals zu dem Operationsverstärker suspendiert ist, und daß ein ein weiteres Feldeffekttransistor-Schaltelement mit dem genannten einen Eingangsendes des Operationsverstärkers verbunden und so angeordnet ist, daß es geschaltet wird, um das Potential des genannten einen Eingangsendes während derselben Zeit gleich dem Referenzpotential zu halten.

2. Integrator nach Anspruch 1, dadurch gekennzeichnet, daß ein zweites, weiteres Feldeffekttransistor-Schaltelement mit dem genannten Ausgangsende des Operationsverstärkers verbunden und so angeordnet ist, daß es geschaltet wird, um das Potential des genannten Ausgangsendes während der Zuführung des Abschaltsignals zum dem Operationsverstärker gleich dem Referenzpotential zu halten.

3. Geschalteter Kondensatorfilter, mit einer Vielzahl von in Reihe geschalteten Integratoren nach einem der vorherigen Ansprüche.

## Revendications

1. Intégrateur, fabriqué sous forme de circuit intégré, à condensateur commuté comprenant un condensateur et un élément de commutation à transistor à effet de champ, lequel élément de commutation peut être périodiquement commuté de façon à charger le condensateur à l'aide d'une tension d'entrée par l'intermédiaire de l'élément de commutation et à décharger le condensateur par l'intermédiaire de l'élément de commutation, un amplificateur opérationnel, connecté par une première de ses extrémités d'entrée au condensateur commuté afin de recevoir des charges de la part du condensateur lorsqu'il est déchargé, et recevant par une autre extrémité d'entrée un potentiel de référence, et un condensateur d'intégration connecté entre une extrémité de sortie de l'amplificateur opérationnel et ladite première extrémité d'entrée de l'amplificateur opérationnel, caractérisé en ce que l'amplificateur opérationnel possède une borne destinée à recevoir un signal de coupure d'énergie en réponse auquel l'alimentation en énergie d'une partie ou de la totalité du circuit de l'amplificateur cesse pour placer l'amplificateur en non-fonctionnement, en ce que la commutation du condensateur est suspendue pendant la durée d'application du signal de coupure d'énergie à l'amplificateur opérationnel, et en ce qu'une élément de commutation à transistor à effet de champ supplémentaire est connecté à ladite première extrémité d'entrée de l'amplificateur opérationnel eh est conçu de façon à être commuté pour maintenir le potentiel de ladite première extrémité d'entrée égal au potentiel de référence pendant cette même durée.

2. Intégrateur selon la revendication 1, caractérisé en ce qu'un deuxième élément de commutation à transistor à effet de champ supplémentaire est connecté à ladite extrémité de sortie de l'amplificateur opérationnel et est conçu de façon à être commuté pour maintenir le potentiel de ladite extrémité de sortie égal au potentiel de référence pendant l'application d'un signal de coupure d'énergie à l'amplificateur opérationnel.

3. Filtre à condensateur commuté, comprenant plusieurs intégrateurs, tels que revendiqués dans l'une quelconque des revendications précédentes, connectés en série.

# FIG. I

# FIG. 2

# FIG. 3

# FIG. 6

# F I G. 4

# FIG. 5

(a) TIME

(b) POWER DOWN

(C) CLOCK

(d) Vini

(e) A POINT — GND

(f) Vout — GND

(g) A POINT — GND

(h) Vout — GND